# EUROPEAN PATENT APPLICATION

(11) **EP 2 112 700 A2**
(43) Date of publication of application: **28.10.2009**
(21) Application number: 09251163.3
(22) Date of filing: 23.04.2009
(51) Int. Cl.: H01L 33/00

(54) **Light-emitting diode package and light-emitting device**

(30) Priority: 23.04.2008 JP 2008112373
(71) Applicant: C. I. Kasei Company, Limited, Tokyo 104-8321 (JP)
(72) Inventor: Fushimi, Hiroshi, Tokyo 104-8321 (JP)
(74) Representative: Faulkner, Thomas John

(57) **Abstract**

This invention relates to an LED package for affixing an LED, and to a light-emitting device in which an LED having upper and lower electrodes is affixed to the LED package.

The LED package of the present invention comprises a shaped body and at least first and second clips that fit on the shaped body. The bottom portion of the shaped body has at least a first opening and a second opening formed therein. Formed around the first and second openings is a light reflecting portion. The opening of the shaped body has an integrally formed fluorescent film attachment portion to which a fluorescent film member is attached. The first clip has a centrally located LED mounting projection, and ends that resiliently engage with the shaped body. The first clip engages with the shaped body by the ends. The second clip has a connecting projection, and ends that resiliently engage with the shaped body.

## Description

### BACKGROUND OF THE INVENTION

### Field of the Invention

This invention relates to a light-emitting diode (LED) package for attaching at least one LED, and to a light-emitting device attached to the LED package that is an LED having upper and lower electrodes. The invention particularly relates to an LED package and light-emitting device having a structure able to deliver a large current to the LED having upper and lower electrodes.

The invention also relates to an LED package and light-emitting device which uses metal ribbon and solder instead of wire bonding to make connections, making it possible to prevent damage to the light-emitting layer of the LED having upper and lower electrodes or broken connections or the like at connecting portions, caused by ultrasonic vibration or thermal stress. The invention relates to a light-emitting device that can efficiently radiate light from the light-emitting portion since the upper surface of the LED is not covered with sealing material.

### Description of the Prior Art:

JP 2007-317896 (A) discloses a light-emitting device comprising a package that has a side surface, a bottom surface, a top surface provided with an opening, and an LED disposed on the bottom surface. The side surface of the package is comprised of a glass layer to which pigment is added to improve the color purity of light emitted by the LED.

The light-emitting device disclosed by the above patent publication uses wire bonding to connect the electrodes of the LED to the package electrodes. When ultrasonic vibration is used to connect the wires to the diode electrodes, there is a risk of damage to the light-emitting layer. There is also a risk that the heat generated in the wire connection portion by the flow of a large current may break the connection. In order to protect the light-emitting layer of the diode and the wire connection, the package is packed with insulation material, but the insulation material can cause a decrease in the emission efficiency of the LED.

To overcome the above problems, it is an object of the present invention to provide an LED package and light-emitting device that are readily fabricated, maintain high strength and are resistant to ultrasonic vibration and thermal stress by using metal ribbon and solder to connect the LED electrodes to the package electrodes.

An object of this invention is to provide an LED package that has good mass-producability by being comprised by simply assembling a shaped body having openings and clips that fit into the openings.

According to one aspect of the present invention, an LED package comprises: an integrally shaped body having a bottom portion in which are formed at least a first opening and a second opening, a light reflecting portion, and a fluorescent film attachment portion to which a fluorescent film member is attached; and at least a first clip having an LED mounting projection that fits in the first opening and ends that resiliently engage with the shaped body, and a second clip having a connecting projection that fits in the second opening and ends that resiliently engage with the shaped body.

The LED package according to said one aspect may further comprise angular recesses formed in the bottom portion of the shaped body into which the first and second clips fit.

A side of the shaped body of the LED package according to said one aspect may have angular recesses that engage with the ends of the first and second clips.

The shaped body of the LED package according to said one aspect may be formed of one selected from ceramics, porous ceramics, and heat-resistant synthetic resin.

The first and second clips of the LED package according to said one aspect may be formed so that each end of each clip is folded over inwards to form an inclined projection.

The ends of the first and second clips of the LED package according to said aspect may have electric power supply terminals.

The electric power supply terminals at each side of the bottom portion of the LED package according to said aspect may project in mutually different directions.

According to another aspect of the present invention, a light-emitting device integrally comprises: a shaped body having a bottom portion in which are formed at least a first opening and a second opening, a light reflecting portion, and a fluorescent film attachment portion to which a fluorescent film member is attached; and at least a first clip having an LED mounting projection that fits in the first opening and ends that resiliently engage with the shaped body, a second clip having a connecting projection that fits in the second opening and ends that resiliently engage with the shaped body, an LED having upper and lower electrodes in which the lower electrode is connected to the LED mounting projection, a metal ribbon that connects the upper electrode of the LED to the connecting projection, and a fluorescent film member provided on an opening of the shaped body.

In the above light-emitting device according to said other aspect of the invention, the LED mounting projection and the lower electrode of the LED having upper and lower electrodes, the upper electrode of the LED and the metal ribbon, and the metal ribbon and the connecting projection may be connected by solder.

In the above light-emitting device according to said other aspect of the invention, a space between the LED and the fluorescent film member may be an air layer.

The LED package of the present invention integrally comprising a bottom portion provided with openings, a light reflecting portion, and a fluorescent film attachment portion to which a fluorescent film member is attached can be readily assembled by just fitting clips into the openings, giving it good mass-producability.

In accordance with this invention, the shaped body and clips can be die-formed readily and quickly, providing good mass-producability as well as low cost.

In accordance with the present invention, instead of wire bonding, solder is used to connect the LED electrodes to the metal ribbon, making the connections highly reliable over a long period of time, in addition to which there is no need to use packing material to seal the LED having upper and lower electrodes, making it possible to obtain a light-emitting device having low cost and good mass-producability.

Since in accordance with the present invention the upper electrode of the LED connected to one of the clips fitted in the shaped body is connected to the other clip by, for example, a ribbon shaped strip or a plate shaped strip of metal, it can take a large flow of current, and in addition has good heat dissipation and can alleviate any thermal stress that is generated. In particular, since the invention uses solder, not wire bonding, to make the connections, connections and/or the light-emitting layer is not subjected to vibration, making it possible to obtain a light-emitting device having good performance.

Since in accordance with this invention, around the LED there is an air layer, not packing material, heat dissipation is good and light emission is not blocked, so the emission efficiency is good.

In accordance with this invention, the package, the first and second clips, the LED having upper and lower electrodes, the metal ribbon and the solder can be readily and quickly assembled by an automated robot. Also, after the first and second clips are pressed, they only need to be fitted onto the package, so the number of steps needed to form the LED package is low, making it possible to produce it readily and quickly, at low cost.

The LED package according to one aspect of the present invention comprises at least a shaped body and first and second clips that fit on the shaped body. At least first and second openings are formed in the bottom portion of the shaped body. A light reflecting portion is formed around the first and second openings, and the opening of the reflecting portion has an integrally formed fluorescent film attachment portion to which a fluorescent film member is attached.

The first clip has a centrally formed LED mounting projection, and the ends of the first clip resiliently engage with the shaped body. The first clip engages with the shaped body by the ends. The second clip has a connecting projection, and ends that resiliently engage with the shaped body. The respective fit between the first and second openings and the first and second clips may be precise or have some play.

The LED package has two angular recesses formed in the bottom portion of the shaped body. The first and second clips fit in the angular recesses, holding the clips still. The first and second clips are formed of conductive material that supplies electric power to an LED affixed to the LED package.

Two angular recesses are formed in the side of the shaped body of the LED package. The ends of the first and second clips engage with the angular recesses, holding the clips still. The angular recesses in the bottom and side portions may be formed in just the bottom portion, in just the side portion, or in both the bottom and side portions.

The shaped body of the LED package may be formed of one selected from ceramics, porous ceramics, and heat-resistant synthetic resin. The inner surface of a shaped body that is formed of porous ceramics can reflect light emitted by the LED. The inner surface of a shaped body formed of ceramics or heat-resistant synthetic resin needs to be provided with a reflecting film or the like. Various engineering plastics can be used as the heat-resistant synthetic resin.

The ends of the first and second clips of the LED package are each folded over inwards to form an inclined projection. The inwardly folded inclined projections have a springiness that provide a firm fit on the shaped body. The LED package of the present invention can be readily and quickly assembled by just clipping the first and second clips onto the shaped body. Resilience may also be imparted to the material of the first and second clips.

The ends of the first and second clips of the LED package form electric power supply terminals. Electric wiring can be readily implemented by connecting electric power supply wiring to one or both of the electric power supply terminals.

With the ends of the first and second clips forming the power supply terminals at each side of the bottom portion of the LED package, a large current can be supplied without distortion to the LED. The electric power supply terminals provided at each end of the first and second clips project in mutually different directions so that there is no mutual contact between them.

In accordance with another aspect of the present invention, a light-emitting device has at least one LED having upper and lower electrodes affixed to the above-described LED package. An array of a plurality of LEDs having upper and lower electrodes may be affixed to the package. The lower electrode of the LED is connected to an LED mounting projection provided on the first clip, and the upper electrode of the LED is connected to a connecting projection of the second clip by a metal ribbon.

An opening of the shaped body comprising the LED package is provided with a fluorescent film member. The fluorescent film member converts light emitted by the LED to a prescribed wavelength to form light of a desired color.

The LED having upper and lower electrodes is connected to the first and second clips by wide metal ribbon, which enables a large current to be supplied to the LED, and since it also increases the surface area, the electrical resistance is lowered, providing good light reflectivity and heat dissipation.

In the above light-emitting device, the LED mounting projection and the lower electrode of the LED having upper and lower electrodes, the upper electrode of the LED and the metal ribbon, and the metal ribbon and the connecting projection are connected by solder. Solder provides a stronger connection than wire bonding, can withstand large currents, without damage to the light-emitting portion caused by ultrasonic vibration or breakage of connections.

Since in the above light-emitting device wire bonding is not used to make the connections, so that connecting portions have high strength, eliminating the need to pack the package with insulation material, the space between the LED and the fluorescent film member is an air layer. Also, because the package is not filled with insulation material, it has good heat dissipation that allows a large current to be supplied to the LED. In accordance with this invention; the package construction, taken together with the use of metal ribbon and solder, enables the use of a large current, making it possible to obtain a high-intensity light-emitting device.

### BRIEF EXPLANATION OF THE DRAINAGES

Figure 1 (a) is a perspective diagram illustrating the shaped body and clips of the package of the present invention, and Figure 1 (b) is a plan view showing the clips in place on the shaped body (first embodiment).

Figure 2 (a) is a plan view of the shaped body, Figure 2 (b) is a cross-sectional view along line A-A of the plan view, Figure 2 (c) is a cross-sectional view along line B-B of the plan view, Figure 2 (d) is a side view of the shaped body, and Figure 2 (e) is a bottom view.

Figure 3 is a diagram for illustrating a light-emitting device in which an LED having upper and lower electrodes is set in the package, with Figure 3 (a) being a bottom view and Figure 3 (b) a cross-sectional view along C-C.

### DESCRIPTION OF THE PREFERRED EMBODIMENTS

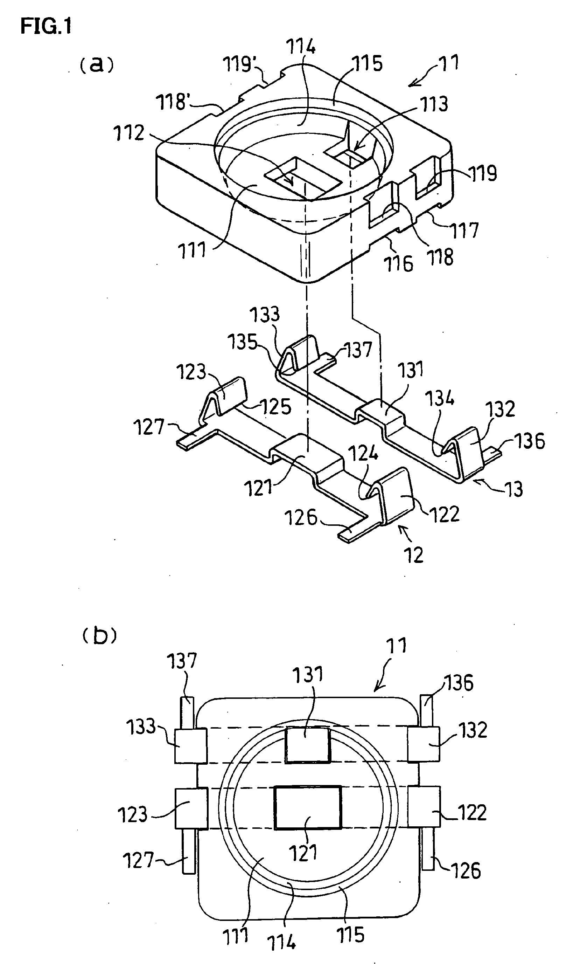

Figure 1 (a) is a perspective diagram illustrating the shaped body and clips of the package of the present invention, and Figure 1 (b) is a plan view showing the clips in place on the shaped body. The package shown in Figure 1 (a) comprises a shaped body 11, and a first clip 12 and a second clip 13 that clip onto the shaped body. Formed in a centrally located bottom portion 111 of the shaped body 11 are a first opening 112 and a second opening 113 into which the first clip 12 and second clip 13 fit. The first opening 112 is formed in the central part of the shaped body 11.

Formed on the underside of the bottom portion 111 are angular recesses 116 and 117 into which the first clip 12 and second clip 13 fit. The shaped body 11 also has a reflecting portion 114 that reflects light from the LED, the reflecting portion 114 being provided on the side portion that extends from the bottom portion 111, and a fluorescent film attachment portion 115 to attach a fluorescent film member. The upper part of the side of the shaped body 11 is also provided with angular recesses 118, 118', 119 and 119' for engagement with the ends of the first clip 12 and second clip 13.

With reference to Figure 1 (a), in the middle of the first clip 12, an LED mounting projection 121 is formed for an LED having upper and lower electrodes, and the ends of the first clip 12 are bent up and folded down to form first engaging portions 122 and 123 for engaging with the angular recesses 118 and 118'. The first engaging portions 122 and 123 have first engagement ends 124 and 125 that engage with the lower ends of the angular recesses 118 and 118'. The first engaging portions 122 and 123 and first engagement ends 124 and 125 are inclined inwards with respect to the package to impart resilience.

Similarly, a metal ribbon connection portion 131 is formed in the middle of the second clip 13, and the ends of the second clip 13 are bent up and folded down to form second engaging portions 132 and 133 for engaging with the angular recesses 119 and 119'. The second engaging portions 132 and 133 have second engagement ends 134 and 135 that engage with the lower ends of the angular recesses 119 and 119'. The second engaging portions 132 and 133 and second engagement ends 134 and 135 are inclined inwards with respect to the package to impart resilience. Also, the first clip 12 and second clip 13 are provided at their bottom edges with respective first terminals 126 and 127 and second terminals 136 and 137 that project in mutually opposite directions.

The shaped body 11 can be die-formed of ceramics, porous ceramics or heat-resistant synthetic resin. In the case of ceramics, ceramic powder or ceramic film casting can be die-formed or the like, then sintered. The first clip 12 and second clip 13 can be manufactured by press-forming of a conductive material such as phosphor bronze. The first clip 12 is fitted on to the shaped body 11 with the LED mounting projection 121 located in the first opening 112 and the first engagement ends 124 and 125 engaged with the lower ends of the angular recesses 118 and 118'.

The second clip 13 is fitted on to the shaped body 11 with the metal ribbon connection portion 131 located in the second opening 113 in the bottom portion and the second engagement ends 134 and 135 engaged with the lower ends of the angular recesses 119 and 119'. Figure 1 (b) is a plan view showing the shaped body 11 and the first clip 12 and second clip 13 assembled together. The first clip 12 and second clip 13 are provided at their bottom edges with respective first terminals 126 and 127 and second terminals 136 and 137 that project in mutually different directions. The size and shape of the shaped body 11, first and second openings 112 and 113, LED mounting projection 121, metal ribbon connection portion 131, first engaging portions 122 and 123, first engagement ends 124 and 125, second engaging portions 132 and 133, second engagement ends 134 and 135, first terminals 126 and 127 and second terminals 136 and 137 are arbitrary.

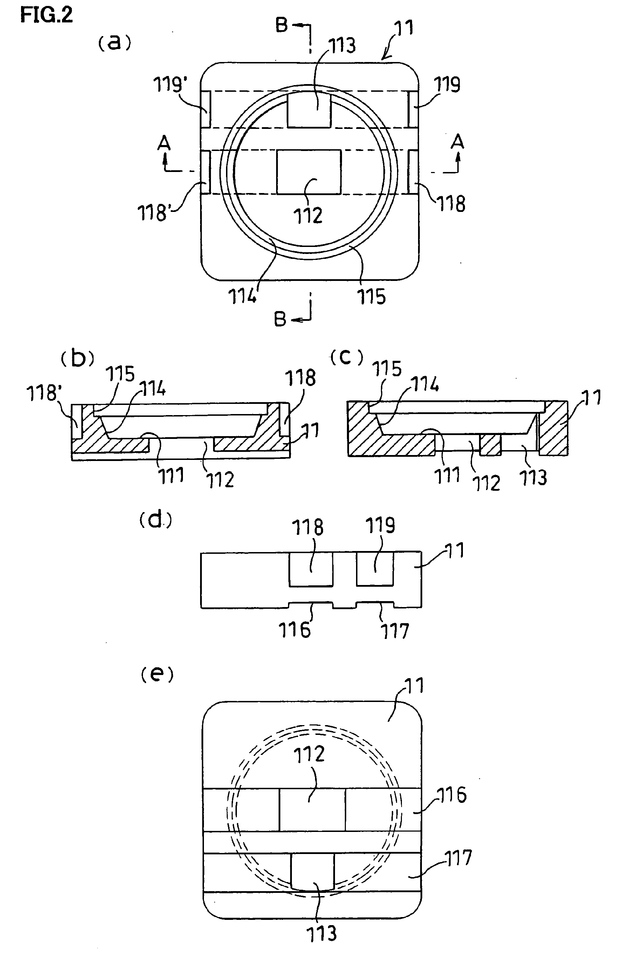

Figure 2 (a) is a plan view of the shaped body, Figure 2 (b) is a cross-sectional view along line A-A of the plan view, Figure 2 (c) is a cross-sectional view along line B-B of the plan view, Figure 2 (d) is a side view of the shaped body, and Figure 2 (e) is a bottom view. The shaped body 11 may be formed of a silicone resin, an epoxy resin, alumina, a composite ceramic of alumina and glass, porous ceramics or other such material.

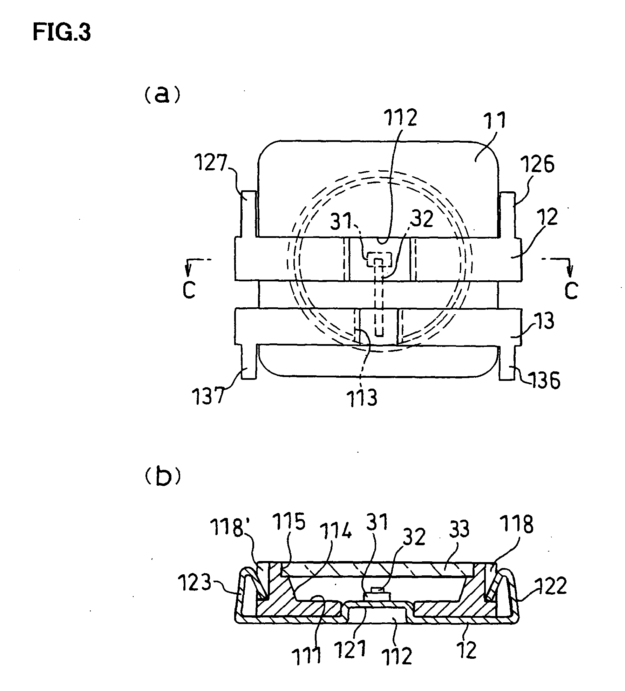

Figure 3 is a diagram for illustrating a light-emitting device in which an LED having upper and lower electrodes is set in the package, with Figure 3 (a) being a bottom view and Figure 3 (b) a cross-sectional view along C-C. After the shaped body 11 is assembled with the first clip 12 and second clip 13, the lower electrode of the LED 31 is connected to the LED mounting projection 121 of the first clip 12. Then, the upper electrode of the LED 31 is connected to metal ribbon 32, and the other end of the metal ribbon 32 is connected to the metal ribbon connection portion 131 of the second clip 13. A fluorescent film member 33 that converts the wavelength of light from the LED 31 to obtain light of a desired color is affixed to the fluorescent film attachment portion 115.

The metal ribbon has, for example, a thickness of 25 µm and a width of from 150 µm to 200 µm. These thickness and width can be varied on the basis of the above sizes. The metal ribbon is formed of rectangular shaped gold, giving it good conductivity and enabling it to carry a large current. Moreover, because the metal ribbon reflects light well, the light is irradiated to the outside with good efficiency, without creating shadows.

The gallium nitride LED 31 having upper and lower electrodes has an active layer between a p-type gallium nitride semiconductor layer and an n-type gallium nitride semiconductor layer. The gallium nitride LED 31 has a light-emitting portion and an upper electrode on one of the semiconductor layers, and the lowermost layer of the other semiconductor layer has a lower electrode that is connected to the LED mounting projection 121 of the first clip 12. The upper surface of the gallium nitride LED has fine ridging formed thereon, enabling a large current to be used to obtain high brightness.

The package may be a square one measuring, for example, 10 mm by 10 mm, and the size of the LED 31 may be, for example, 1.0 mm by 1.0 mm by 0.14 mm thick.

The invention is not limited to the above-described embodiments and aspects, and may be modified to the extent that such modification does not depart from the scope of the matter described in the claims herein. The number of LEDs in the package may be increased and connected in rows between the first clip 12 and second clip 13, or a third clip or the like may be added to connect the LEDs in series. As the fluorescent member layer and LED having upper and lower electrodes used in the present invention, there may be used fluorescent member layers and LEDs that are publicly known or well-known. Publicly known or well-known ceramics and heat-resistant synthetic resins may be used for the shaped body of the invention. There is no particular limitation on the clips of the invention, as long as they can be press-formed and have springiness.

## Claims

1. An LED package, comprising:
an integrally shaped body having a bottom portion in which are formed at least a first opening and a second opening, a light reflecting portion, and a fluorescent film attachment portion to which a fluorescent film member is attached; and at least
a first clip having an LED mounting projection that fits in the first opening and ends that resiliently engage with the shaped body; and
a second clip having a connecting projection that fits in the second opening and ends that resiliently engage with the shaped body.

2. The LED package as set forth in claim 1, further comprising angular recesses formed in the bottom portion of the shaped body into which the first and second clips fit.

3. The LED package as set forth in claim 1 or 2, wherein a side of the shaped body has angular recesses that engage with ends of the first and second clips.

4. The LED package as set forth in any of claims 1 to 3, wherein the shaped body is formed of one selected from ceramics, porous ceramics, and heat-resistant synthetic resin.

5. The LED package as set forth in any of claims 1 to 4, wherein each end of each clip is folded over inwards to form an inclined projection.

6. The LED package as set forth in any of claims 1 to 5, wherein the ends of the first and second clips have electric power supply terminals.

7. The LED package as set forth in any of claims 1 to 6, wherein the electric power supply terminals at each side of the bottom portion project in mutually different directions.

8. A light-emitting device, comprising:
an integrally shaped body having a bottom portion in which are formed at least a first opening and a second opening, a light reflecting portion, and a fluorescent film attachment portion to which a fluorescent film member is attached; and at least
a first clip having an LED mounting projection that fits in the first opening and ends that resiliently engage with the shaped body;
a second clip having a connecting projection that fits in the second opening and ends that resiliently engage with the shaped body;
an LED having upper and lower electrodes in which the lower electrode is connected to the LED mounting projection;
a metal ribbon that connects the upper electrode of the LED to the connecting projection; and
a fluorescent film member provided on an opening of the shaped body.

9. The light-emitting device as set forth in claim 8, wherein the LED mounting projection and the lower electrode of the LED having upper and lower electrodes, the upper electrode of the LED and the metal ribbon, and the metal ribbon and the connecting projection are connected by solder.

10. The light-emitting device as set forth in claim 8 or 9, wherein a space between the LED and the fluorescent film member is an air layer.
